(19) Europäisches Patentamt
European Patent Office
Office européen des brevets

(11) **EP 0 997 031 B1**

(12) **EUROPEAN PATENT SPECIFICATION**

(45) Date of publication and mention
of the grant of the patent:
**19.09.2007 Bulletin 2007/38**

(21) Application number: **98935383.4**

(22) Date of filing: **30.07.1998**

(51) Int Cl.:
*H03M 13/29* *(2006.01)*

(86) International application number:
**PCT/KR1998/000232**

(87) International publication number:
**WO 1999/007076 (11.02.1999 Gazette 1999/06)**

(54) **ADAPTIVE CHANNEL ENCODING METHOD AND DEVICE**

VERFAHREN UND SCHALTUNG ZUR ADAPTIVEN KANALKODIERUNG

PROCEDE ET DISPOSITIF DE CODAGE CANAL ADAPTATIF

(84) Designated Contracting States:
**DE ES FI FR GB IT SE**

(30) Priority: **30.07.1997 KR 9736265**
**10.11.1997 KR 9760101**

(43) Date of publication of application:
**03.05.2000 Bulletin 2000/18**

(60) Divisional application:
**05016017.5 / 1 601 109**

(73) Proprietor: **SAMSUNG ELECTRONICS CO. LTD.**
**Kyungki-do 442-270 (KR)**

(72) Inventors:
• **PARK, Chang, Soo**
**Seoul 134-023 (KR)**
• **LEE, Hyeon, Woo**
**Suwon-shi,**
**Kyonggi-do 441-390 (KR)**
• **LEE, Pil, Joong**
**Seoul 121-220 (KR)**
• **KONG, Jun, Jin**
**Songnam-shi,**
**Kyonggi-do 461-162 (KR)**
• **KIM, Yong c/o Samsung Electronics Co., Ltd.**
**Seong-Nam shi, Kyungki-do, 463-050 (KR)**

(74) Representative: **Grünecker, Kinkeldey,**
**Stockmair & Schwanhäusser**
**Anwaltssozietät**
**Maximilianstrasse 58**
**80538 München (DE)**

(56) References cited:
**WO-A1-97/40582**     **GB-A- 2 296 165**
**US-A- 4 901 319**

• **DOLINAR S, DIVSALAR D: "Weight Distributions for Turbo Codes Using Random and Nonrandom Permutations" JET PROPULSION LABORATORY TDA PROGRESS REPORT, no. 42-122, 15 August 1995 (1995-08-15), pages 56-65, XP000863600**
• **BLACKERT W, HALL E, WILSON S: "Turbo code termination and interleaver conditions" ELECTRONIC LETTERS, vol. 31, no. 24, 23 November 1995 (1995-11-23), pages 2082-2084, XP006003664**
• **BERROU C, GLAVIEUX A: "Near Optimum Error Correcting Coding And Decoding: Turbo-Codes" IEEE TRANSACTIONS ON COMMUNICATIONS, vol. 44, no. 10, pages 1261-1271, XP000629465**
• **BARBERIS S ET AL.: "Radio Transmission and Capacity Comparisons between ATDMA and CODIT Systems for UMTS" 47TH IEEE VEHICULAR TECHNOLOGY CONFERENCE, 4 May 1997 (1997-05-04), pages 815-819, XP010228956**
• **JUNG P, NASSAN M, BLANZ J: "Application of Turbo-Codes to a CDMA Mobile Radio System Using Joint Detection and Antenna Diversity" 44TH IEEE VEHICULAR TECHNOLOGY CONFERENCE, 8 June 1994 (1994-06-08), pages 770-774, XP010123179**
• **BÖMER L ET AL.: "A CDMA Radio link with 'Turbo-Decoding': Concept and Performance Evaluation" 6TH IEEE SYMPOSIUM ON PERSONAL, INDOOR AND MOBILE RADIO COMMUNICATIONS, 27 September 1995 (1995-09-27), pages 788-798, XP010150891**

EP 0 997 031 B1

- CHAEHAG YI, JAE HONG LEE: "Interleaving and Decoding Scheme for a Product Code for a Mobile Data Communication" IEEE TRANSACTIONS ON COMMUNICATIONS, vol. 45, no. 2, 2 February 1997 (1997-02-02), pages 144-147, XP000694661

- DIVSALAR D, POLLARA F: "Turbo Codes for Deep-Space Communications" JET PROPULSION LABORATORY, PROGRESS REPORT 42-120, 15 February 1995 (1995-02-15), page 29-39, XP002317264 PASADENA, CA, US

**Description**

**BACKGROUND OF THE INVENTION**

1. Field of the Invention

The present invention relates to adaptive channel encoding methods and devices for communications systems, and in particular, to adaptive channel encoding methods and devices for use in transmission of voice and data.

2. Description of the Related Art

A turbo encoder, constituted in a parallel or serial structure, generates parity symbols from an input N-information bit frame with two simple component (or constituent) encoders. It uses a recursive systematic convolutional (RSC) code as a component (or constituent) code.

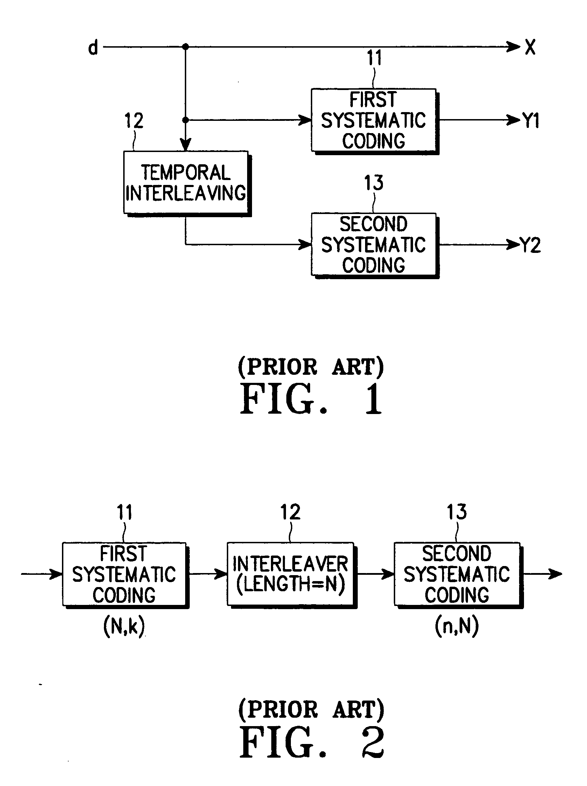

FIG. 1 is a block diagram of a conventional parallel turbo encoder, disclosed in U.S. Patent No. 5,446,747 by Berrou. In the turbo encoder of FIG. 1, an interleaver 12 is interposed between first and second component encoders 11 and 13. The interleaver 12 has a size equivalent to the frame length N of the input information bits, and modifies the sequence of information bits received in the second component encoder 13 to reduce correlation between information bits. FIG. 2 is a block diagram of a conventional serial turbo encoder also having the interleaver 12 connected between the first and second component encoders 11 and 13.

The above turbo encoders produce a turbo code for use in space communications. Though a constraint length K in the component encoders 11 and 13 is shorter than that of a conventional convolutional code (i.e., K=9), the interleaver 12 uses a very large memory, resulting in a very long delay at decoding.

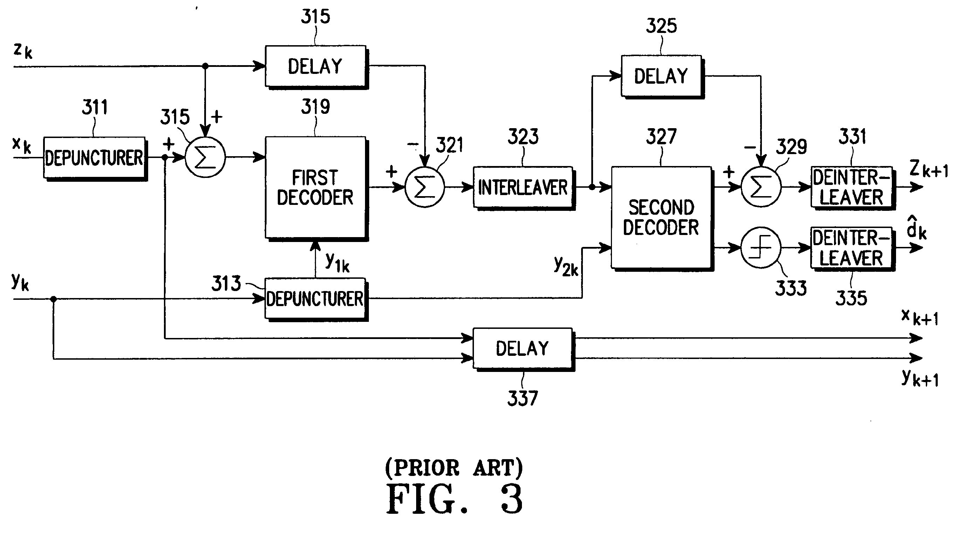

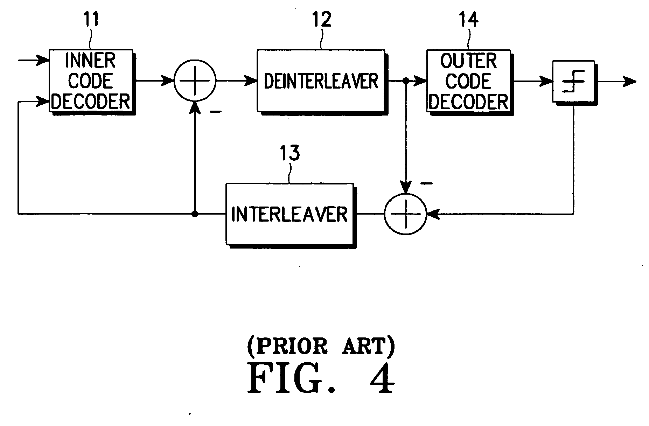

FIG. 3 is a block diagram of a turbo decoder for decoding the output of the parallel turbo encoder shown in FIG. 1, also disclosed in U.S. Patent No. 5,446,747 by Berrou. FIG. 4 is a block diagram of a turbo decoder for decoding the output of the serial turbo encoder shown in FIG. 2, proposed by Benedetto in an article of IEEE Electronics Letters, Vol. 32, No. 13, June 1996.

The parallel turbo decoder of FIG. 3 advantageously enhances performance characteristics in terms of bit error rate (BER) by repeatedly decoding input data in frame units, using an iterative decoding algorithm. An interleaver 323 contributes to an increase in an error correction capability by distributing burst error patterns which were not corrected by a first decoder 319, prior to correction of the burst error patterns in a second decoder 327.

The iterative decoding refers to repeated decoding of symbols which were decoded in a specific procedure, using resulting extrinsic information, to achieve excellent decoding performance. Iterative decoding algorithms are SOVA (Soft-Output Viterbi Algorithm: see Proceedings of IEEE Vehicular Technology Conference, pp. 941-944, May 1993) and MAP (Maximum Aposteriori Probability: see IEEE Transactions on Information Theory, pp. 429-445, Vol. 42, No. 2, March 1996). SOVA is a modification of a Viterbi algorithm which produces a soft decision output and can minimize codeword error rate. On the other hand, MAP can minimize symbol error rate.

In the decoder of FIG. 3, outputs $y_{1k}$ and $y_{2k}$ of a depuncturer 313 are $y_k$ and zero, respectively, when a parity symbol $y_k$ is received from the first component encoder 11 of FIG. 1, whereas they are zero and $y_k$, respectively, when the parity symbol $y_k$ is received from the second component encoder 13 of FIG. 1. $Z_{k+1}$ is a soft decision symbol used as extrinsic information in an iterative decoding algorithm and an input for decoding in a next stage. A final intended symbol is obtained by subjecting $Z_{k+1}$ to hard decision. The performance of the turbo code depends on interleaver size, interleaver structure, and the number of iterative decodings.

As shown in FIG. 1, the turbo encoder includes the interleaver 12. The interleaver 12 causes turbo encoding/decoding to be implemented in frame units. Thus, the complexity of turbo code is proportional to the product of frame size of a memory necessary for first and second iterative decoders 319 and 327 shown in FIG. 3 and the state number of component codes for the first and second component encoders 11 and 13. The turbo code cannot find its application in voice and data transmission due to use of very large frames. Increasing the state number of the component codes for the turbo encoder in order to achieve better performance leads to increased complexity of the first and second component encoders 11 and 13.

With a burst error in the decoder as shown in FIG. 3, the output of the first iterative decoder 319 has a correlation, which impedes reliable decoding in the second iterative decoder 327 in the next decoding stage. Hence, errors are incurred in a whole block and cannot be corrected in a next iterative decoding stage. In this context, there is an ever increasing need for an interleaver and a deinterleaver which can distribute burst errors in a single frame of a code subject to iterative decoding without correlation.

Due to the advantage of low correlation, a random interleaver increases the performance of the turbo code. With small frame size, however, the random interleaver has limitations in its effectiveness for distributing burst errors without correlation and requires a look-up table. Hence, voice transmission or low-rate data transmission require small frame size and a small number of component code states to minimize delay time. Voice transmission or low-rate data transmission further need a structured interleaver. In short, the conventional turbo code is not viable in the voice and data transmission because of the unacceptability of the constraint length of the component codes and the large interleaver. Nevertheless, efforts are increasingly expended on realization of an encoder and a decoder for a communications system, taking the advantages of the conventional turbo code into account.

Therefore, a need exists for a turbo encoder having a performance equal to or higher than that of a convolutional encoder in a conventional communications system. A further need exists for an interleaver having excellent performance with small component code states and minimized delay time. Though the performance of the interleaver 12 of FIG. 1 or 2 for use in a turbo encoder is generally proportional to the interleaver size, the frame size of the turbo code is limited. In this case, it is preferable to use an interleaver that maximizes a minimum hamming distance of the turbo code in terms of a block code. A structured interleaver can be employed for small frames.

In W. Blackert et al.: "Turbo code termination and interleaver condition", Electronic Letters, Vol. 31, No. 24, 23 November 1995 (XP6003664), it is referred to turbo code termination and interleaver conditions. Constituent encoders are used, together with interleavers, wherein a corresponding recursive systematic convolutional encoder is illustrated. An input sequence u consisting of a (N-v)-bit message, which is followed by a v-bit terminating tail, starting in a corresponding data sequence, will then be interleaved. That means that the data sequence of both or all encoders is interleaved, wherein it is not disclosed that the interleaving is adapted to the number of input information bits or about the tail bits. It is only said that the input sequence of the corresponding encoders consists of bit message and also bit terminating tail.

In Bömer et al.: "A CDMA Radio link with Turbo-Decoding: Concept and Performance Evaluation", 6th IEEE Symposium on Personal, Indoor and Mobile Radio Communications, 27-29 September 1995, pages 788 - 793, a CDMA radio link with a turbo decoding scheme is disclosed. In particular, the interleaver sizes are considered. The corresponding features of a general encoding method or turbo encoder are not disclosed.

D. Divsalar, F. Pollara: "Turbo Codes for Deep-Space Communications", TDA progress report 42-120, Jet Propulsion Laboratory, Pasadena, CA, US, 15.02.1995, pages 29 to 39, discloses a trellis termination for component encoders, which are recursive. Corresponding termination sequence depends on the state of each component encoder after N bits. A Switch is used that is in a certain position for first N clock cycles and in a second position for M additional cycle, which will flush the encoders with zeros. Such determination method can be used for unequal rate and memory encoders.

## Summary of the Invention

It is an object of the invention to improve a turbo encoder and corresponding channel encoding methods, such that same may be used in voice and data transmission with an interleaver having excellent performance reducing the state number of component encoder, thereby decreasing the complexity of the decoder.

This object is solved by the features of claims 1 and 5.

The sub claims disclose advantageous embodiments of the invention.

## Brief Description of the Drawings

The above objects and advantages of the present invention will become more apparent by describing in detail preferred embodiments thereof with reference to the attached drawings in which:

FIG. 1 is a block diagram of a conventional parallel concatenated recursive systematic encoder;

FIG. 2 is a block diagram of a conventional serial concatenated recursive systematic encoder;

FIG. 3 is a block diagram of a conventional parallel concatenated recursive systematic decoder;

FIG. 4 is a block diagram of a conventional serial concatenated recursive systematic decoder;

FIG. 5 is a block diagram of a first concatenated recursive systematic encoder that may be used according to the present invention;

FIG. 6 is a block diagram of a second concatenated recursive systematic encoder that may be used according to the present invention;

FIG. 7 is a block diagram of a diagonal and circular interleaver in a turbo encoder;

FIG. 8 is a flowchart showing a first diagonal interleaving operation in the diagonal interleaver of FIG. 7;

FIG. 9 is a flowchart showing a second diagonal interleaving operation in the diagonal interleaver of FIG. 7;

FIG. 10 is a flowchart showing a first circular shifting interleaving operation in the circular shifting interleaver of FIG. 7;

FIG. 11 is a flowchart showing a second circular shifting interleaving operation in the interleaver circular shifting of FIG. 7;

FIG. 12 is a graph showing characteristics of a turbo encoder relying on random and block interleavings versus those of the turbo encoder relying on circular shifting interleaving; and

FIG. 13 is a block diagram of a turbo encoder according to the present invention, referred to for describing tail bit generation and puncturing.

## Detailed Description of Preferred Embodiments

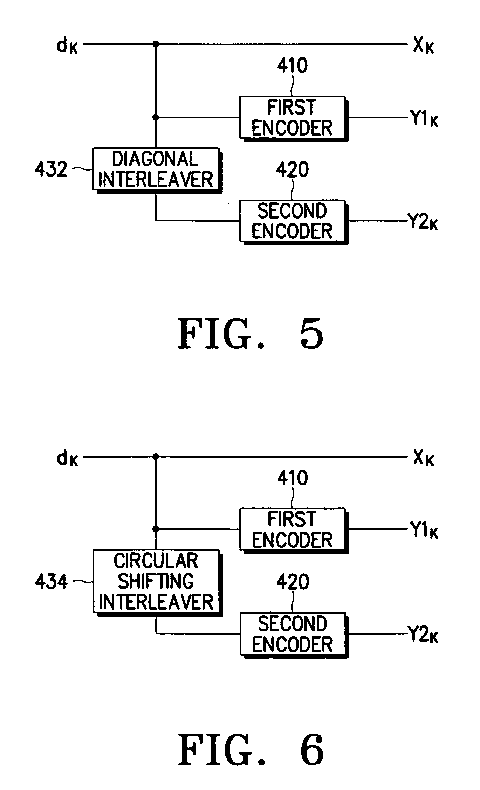

For clarity of description, the embodiments of the present invention are described with reference to a parallel concatenated recursive turbo encoder, other configurations are contemplated such as a serial recursive turbo encoder. FIGS. 5 and 6 are block diagrams of turbo encoders. Encoders 410 and 420 are component encoders for encoding an input information bit $d_k$ to a parity symbol $Y_k$ similar to the component encoders of FIGS. 1 and 2. A diagonal interleaver 432 and a circular shifting interleaver 434 are a feature of the present invention and will be called an interleaver 430 unless a specific one is referred to.

Referring to FIGS. 5 and 6, information bits $d_k$ are simultaneously fed to the first component encoder 410 and the interleaver 430. The interleaver 430 modifies the order in which the information bits are arranged and, preferably, maximizes a minimum Hamming distance of an encoded ouput sequence ($X_k$, $Y_k$) corresponding to the information bits $d_k$. A data frame input to the channel encoder is variable in length because a CRC (Cyclic Redundancy Check) bit and other control bits are added to data. To forcedly fix the data frame length, dummy bits should be added depending on the difference between frame size and interleaver size. But, since these dummy bits have nothing to do with improvement of system performance, it is desirable to reduce them. Thus, the interleaver 430 provides excellent performance and reliable operation regardless of a variation in frame size-associated parameters.

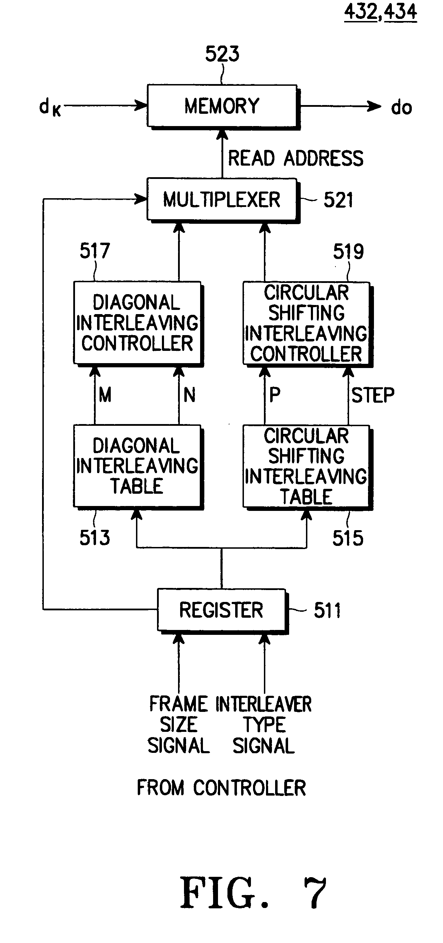

FIG. 7 is a block diagram of the diagonal interleaver 432 and the circular shifting interleaver 434 shown in FIGS. 5 and 6, respectively. Both the diagonal and circular shifting interleavers 432 and 434 analyse their corresponding variable frame sizes upon receipt of information bits and perform an optimum interleaving on the input information bits by interleaver related parameters received from a system controller according to the frame size analysis results. The diagonal interleaver 432 and the circular shifting interleaver 434 are combined into one in description of the embodiments of the present invention, however, a turbo encoder may specifically employ either diagonal interleaving or circular shifting interleaving, separately. Hereinbelow, the diagonal interleaver 432 and the circular shifting interleaver 434 are referred to as the interleaver 430.

Referring to FIG. 7, a register 511 stores a frame size signal and an interleaver type signal received from a system controller (not shown). A diagonal interleaving table 513 stores the numbers M and N of columns and rows in a matrix allowing optimum diagonal interleaving characteristics with respect to frame size during diagonal interleaving. That is, it stores measured MxN values which enable optimum diagonal interleaving of information bits with a variable frame size. The diagonal interleaving table 513 outputs an MxN value corresponding to the frame size signal received from the register 511. A diagonal interleaving controller 517 receives the MxN value from the diagonal interleaving table 513 and generates a read address for interleaving the information bits in a designated interleaving method.

A circular shifting interleaving table 515 stores hop parameters P and step parameters STEP allowing optimum circular shifting interleaving characteristics with respect to the frame size of the information bits in the case of circular shift interleaving. The hop parameters P and the step parameters STEP are empirically measured. The circular shifting interleaving table 515 outputs parameters P and STEP corresponding to the frame size signal received from the register 511. A circular shifting interleaving controller 519 receives the parameters P and STEP from the circular shifting interleaving table 515 and generates a read address for interleaving the information bits in a designated circular shifting interleaving method. A multiplexer 521 receives the read addresses from the diagonal interleaving controller 517 and the circular shifting interleaving controlling 519 and selects on of them in accordance with the interleaver type signal received from the register 511. A memory 523 received the information bits sequentially and outputs the information bits stored at the read address received from the multiplexer 521 in an interleaved order. The memory 523 is designed to be large enough to accommodate information bits with a maximum variable frame size.

For a structure with only the diagonal interleaver 432 in FIG. 7, the register 511, the diagonal interleaving table 513, the diagonal interleaving controller 517, and the memory 523 are included. On the other hand, for a structure with only the circular shifting interleaver 434 in FIG. 7, the register 511, the circular shifting interleaving table 515, the circular shifting interleaving controller 519, and the memory 523 are included. Both the cases do not need the multiplexer 521 and the interleaver type signal if only one type of interleaving is employed.

The diagonal interleaving table 513 and the circular shifting interleaving table 515 may be composed of a memory like a ROM or a RAM, or logical devices in combination. The diagonal interleaving controller 517 and the circular shifting interleaving controller 519 can be realized, using logical devices in combination or a digital signal processor.

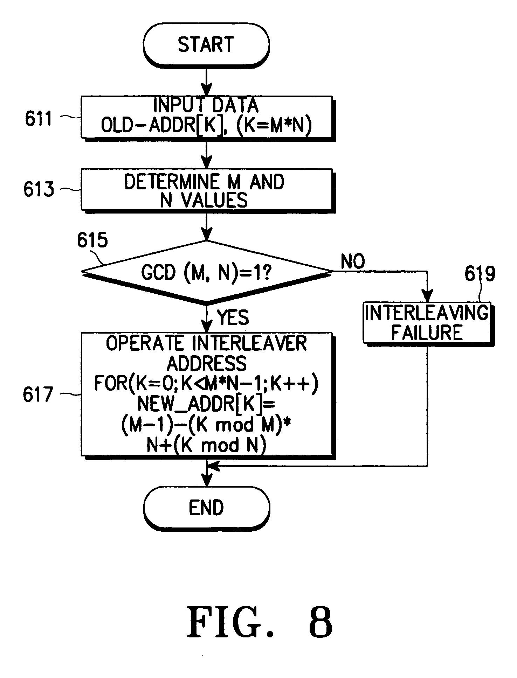

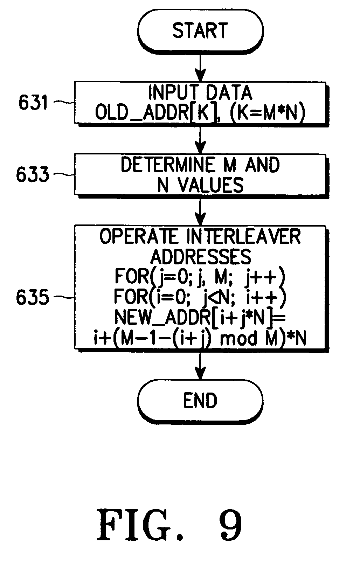

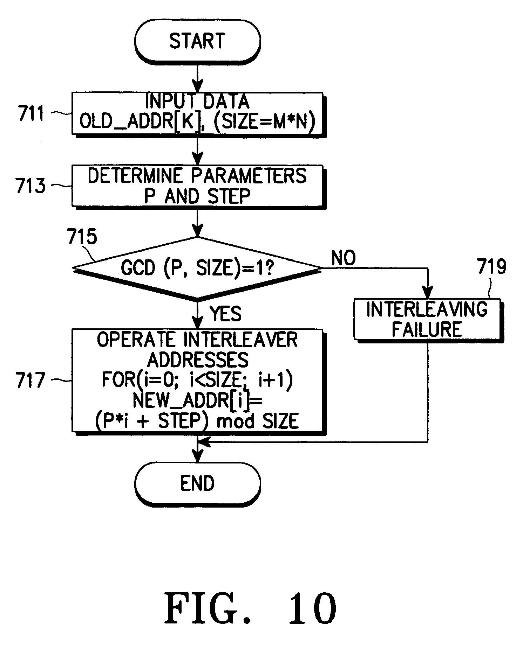

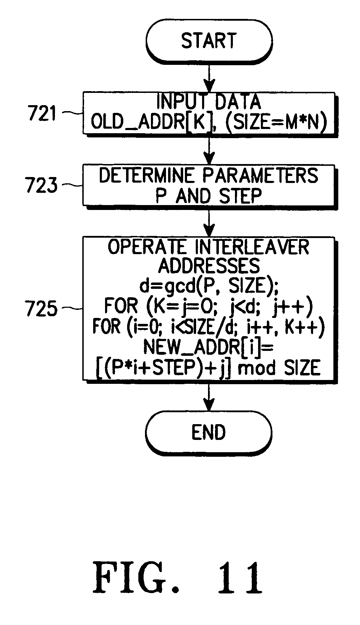

FIGS. 8 and 9 are flowcharts of exemplary diagonal interleavings, and FIGS. 10 and 11 are flowcharts of exemplary circular shifting interleavings. An interleaver which shall be described below, by way of example, has an input buffer.

Referring to the structure of the interleaver 430 shown in FIG. 7, first to third diagonal interleaving operations will be described hereinbelow.

FIG. 8 is a flowchart of the first diagonal interleaving operation. In FIG. 8, the first diagonal interleaving includes a process of reordering an input bit sequence in an MxN matrix. For the first diagonal interleaving, upon receipt of information bits $d_k$, the information bits are stored at addresses old_addr[k] for sequentially storing the information bits in the memory 523 (FIG. 7) and the data frame size k is determined, in step 611. Then, the column and row parameters MxN of the data frame for diagonal interleaving is determined in step 613. That is, to implement diagonal interleaving, the MxN value is designated from the diagonal interleaving table on the basis of the input frame data size k. A plurality of MxN values may be stored in a look-up table to be selected according to the input frame size k. Alternatively, an optimum MxN may be calculated according to the input frame size k. In step 615, it is determined whether the greatest common divisor (GCD) of M and N is 1. When the GCD of M and N is 1, first diagonal interleaving addresses are operated as follows, in step 617.

$$for\ (k = 0;\ k < M * N-1;\ k + +)$$
$$new\ addr[k] = (M - 1 - (k\ mod\ N)) * N + (k\ mod\ N)\ \ldots\ \ldots\ (1)$$

Following the designation of the addresses in an output buffer as in equation (1), the input information bits stored in the input buffer are interleaved and stored in the output buffer.

If the GCD of M and N is not 1, that is, [GCD (M, N) ≠ 1] in step 615, it is determined that the interleaving fails in step 619 and the procedure is terminated.

In the first diagonal interleaving, assuming that a data sequence with M = 6 and N = 5 stored in old_addr[k] is {0 1 2 3 4 5 6 7 8 9 10 11 12 13 14 15 16 17 18 19 20 21 22 23 24 25 26 27 28 29}, a first diagonal interleaver output sequence stored in new_addr[k] of the output buffer is {25 21 17 13 9 0 26 22 18 14 5 1 27 23 19 10 6 2 28 24 15 11 7 3 29 20 16 12 8 4}.

The input data and the first diagonal interleaver output are tabulated in MxN matrixes as follows.

[Table 1]

| input sequence (M = 6, N = 5) | | | | | interleaved sequence (M = 6, N = 5) | | | | |
|---|---|---|---|---|---|---|---|---|---|
| 0 | 1 | 2 | 3 | 4 | 25 | 21 | 17 | 13 | 9 |
| 5 | 6 | 7 | 8 | 9 | 0 | 26 | 22 | 18 | 14 |
| 10 | 11 | 12 | 13 | 14 | 5 | 1 | 27 | 23 | 19 |
| 15 | 16 | 17 | 18 | 19 | 10 | 6 | 2 | 28 | 24 |
| 20 | 21 | 22 | 23 | 24 | 15 | 11 | 7 | 3 | 29 |
| 25 | 26 | 27 | 28 | 29 | 20 | 16 | 12 | 8 | 4 |

However, the above first diagonal interleaving is viable only when the GCD of M and N is 1. When the GCD (M, N) ≠ 1, for example, M = 6 and N = 6, the first diagonal interleaving is impossible and the same data is overwritten as shown in table 2.

[Table 2]

| input sequence (M = 6, N = 6) | | | | | | interleaved sequence (M = 6, N = 6) | | | | | |
|---|---|---|---|---|---|---|---|---|---|---|---|
| 0 | 1 | 2 | 3 | 4 | 5 | 30 | 25 | 20 | 15 | 10 | 5 |
| 6 | 7 | 8 | 9 | 10 | 11 | 30 | 25 | 20 | 15 | 10 | 5 |

(continued)

| input sequence (M = 6, N = 6) | | | | | | interleaved sequence (M = 6, N = 6) | | | | | |
|---|---|---|---|---|---|---|---|---|---|---|---|
| 12 | 13 | 14 | 15 | 16 | 17 | 30 | 25 | 20 | 15 | 10 | 5 |
| 18 | 19 | 20 | 21 | 22 | 23 | 30 | 25 | 20 | 15 | 10 | 5 |
| 24 | 25 | 26 | 27 | 28 | 29 | 30 | 25 | 20 | 15 | 10 | 5 |
| 30 | 31 | 32 | 33 | 34 | 35 | 30 | 25 | 20 | 15 | 10 | 5 |

Second and third diagonal interleavings include a process for permuting an input information bit sequence expressed in an MxN matrix and enable input data to be interleaved regardless of the GCD (M, N) = 1 or ≠ 1.

FIG. 9 is a flowchart of the second diagonal interleaving operation. Referring to FIG. 9, the second diagonal interleaving reorders input bits in an MxN matrix and is applicable to both of cases where the GCD (M, N) = 1 and where the GCD (M, N) ≠ 1. In the second diagonal interleaving, upon input of the information bits $d_k$, the information input bits are stored in addresses old_addr [k] and the frame size k is determined, in step 631. A column and row parameter (MxN) for diagonal interleaving is determined in step 633. In step 635, second diagonal interleaving addresses are operated by

$$for\ (j = 0;\ j < M;\ j + +)$$
$$for\ (i = 0;\ i < N;\ i + +)$$
$$new\ addr[i + j + N] = i + (M - 1 - (i + j)\ mod\ M) * N\ .\ .\ .\ .$$

$$.\ (2)$$

where and $i$ and $j$ increment frame location.

Following the designation of the addresses of the output buffer as in equation (2), the information bits stored in the input buffer are interleaved and stored in the output buffer.

The second diagonal interleaved output corresponding to an input sequence with M = 6, N = 5, and the GCD (M, N) = 1 is shown in table 3.

[Table 3]

| input sequence (M = 6, N = 5) | | | | | interleaved sequence (M = 6, N = 5) | | | | |
|---|---|---|---|---|---|---|---|---|---|
| 0 | 1 | 2 | 3 | 4 | 25 | 21 | 17 | 13 | 9 |
| 5 | 6 | 7 | 8 | 9 | 20 | 16 | 12 | 8 | 4 |
| 10 | 11 | 12 | 13 | 14 | 15 | 11 | 7 | 3 | 29 |
| 15 | 16 | 17 | 18 | 19 | 10 | 6 | 2 | 28 | 24 |
| 20 | 21 | 22 | 23 | 24 | 5 | 1 | 27 | 23 | 19 |
| 25 | 26 | 27 | 28 | 29 | 0 | 26 | 22 | 18 | 14 |

In addition, an input sequence with M = 6, N = 6, and the GCD (M, N) ≠ 1 is interleaved as shown in

[Table 4]

| input sequence (M = 6, N = 6) | | | | | | interleaved sequence (M = 6, N = 6) | | | | | |
|---|---|---|---|---|---|---|---|---|---|---|---|
| 0 | 1 | 2 | 3 | 4 | 5 | 30 | 25 | 20 | 15 | 10 | 5 |
| 6 | 7 | 8 | 9 | 10 | 11 | 24 | 29 | 14 | 9 | 4 | 35 |
| 12 | 13 | 14 | 15 | 16 | 17 | 18 | 13 | 8 | 3 | 34 | 29 |
| 18 | 19 | 20 | 21 | 22 | 23 | 12 | 7 | 2 | 33 | 28 | 23 |
| 24 | 25 | 26 | 27 | 28 | 29 | 6 | 1 | 32 | 27 | 22 | 17 |
| 30 | 31 | 32 | 33 | 34 | 35 | 0 | 31 | 26 | 21 | 16 | 11 |

In the third diagonal interleaving, the diagonal interleaving controller 517 can be implemented by

$$for\ (j\ =\ 0;\ j\ <\ M;\ j\ +\ +)$$
$$for\ (i\ =\ 0;\ i\ <\ N;\ i\ +\ +)$$
$$new\ addr\ [i\ +\ j\ +\ N]\ =\ i\ +\ ((i\ +\ j)\ mod\ M)\ *\ N\ .\ .\ .\ .\ .\ (3)$$

An input sequence is stored at addresses of a mapped memory and then sequentially read by columns or rows by the diagonal interleaver 432. Otherwise, the input sequence is sequentially stored in the memory by columns or rows and read from an address bit by bit by the diagonal interleaver 432.

Deinterleaving is implemented in an order reverse to that of interleaving input data.

FIG. 10 is a flowchart of a first circular interleaving implemented by the circular shifting interleaver 434. The first circular shifting interleaving operation is a data reordering procedure in a predetermined interval, considering an input sequence as a circle. The first circular shifting interleaving operation can interleave an input sequence regardless of its length.

Referring to FIG. 10, input information bits $d_k$ are stored at addresses old_addr [k] of an input buffer, and frame size is determined in step 711. Parameters P and STEP are determined in step 713. Here, P is a hop interval parameter determining the performance of a circular shifting interleaver and thus empirically obtained to achieve an optimum effect. In addition, STEP is a parameter for shifting data from a location hopped by P to the left or right and has an integer value. Then, it is determined whether the GCD of P and SIZE is 1 in step 715. When the GCD (P, SIZE) = 1, first circular shifting interleaving addresses are computed, in step 717, by

$$for\ (i\ =\ 0;\ i\ <\ SIZE;\ i\ +\ +)$$
$$new\ addr[i]\ =\ (p\ *\ i\ +\ STEP)\ mod\ SIZE\ .\ .\ .\ .\ .\ (4)$$

where i is a parameter representative of the frame size of the input data or less than that of the input data frame size, ranging from zero to SIZE, that is, the number of addresses, SIZE is a frame size, p is a natural number satisfying the GCD (SIZE, p) = 1, and STEP is an integer and indicative of a starting point.

For example, the first circular shifting interleaved output, stored in new_addr[k] of the buffer, corresponding to an input sequence with SIZE = 30 stored in new_addr[k] of the input buffer, that is, {0 1 2 3 4 5 6 7 8 9 10 11 12 13 14 15 16 17 18 19 20 21 22 23 24 25 26 27 28 29} is {0 11 22 3 14 25 6 17 28 9 20 1 12 23 4 15 26 7 18 29 10 21 2 13 24 5 16 27 8 19} if P = 11 and STEP = 0. The input sequence and the first circular shifting interleaved output sequence are tabulated as in

[Table 5]

| input sequence (M = 6, N = 5) | | | | | interleaved sequence (M=6, N=5, p=11) | | | | |
|---|---|---|---|---|---|---|---|---|---|
| 0 | 1 | 2 | 3 | 4 | 0 | 11 | 22 | 3 | 14 |
| 5 | 6 | 7 | 8 | 9 | 25 | 6 | 17 | 28 | 9 |
| 10 | 11 | 12 | 13 | 14 | 20 | 1 | 12 | 23 | 4 |
| 15 | 16 | 17 | 18 | 19 | 15 | 26 | 7 | 18 | 29 |
| 20 | 21 | 22 | 23 | 24 | 10 | 21 | 2 | 13 | 24 |
| 25 | 26 | 27 | 28 | 29 | 5 | 16 | 27 | 8 | 19 |

However, with the GCD (SIZE, p) ≠ 1 and p = 6, the first circular shifting interleaving is not viable because the same data is overwritten.

Assuming that SIZE = 30 for an input sequence stored in a sequential address old_addr[k] of an initial memory, P = 11, and STEP = 0, a corresponding interleaved output resulting from the first circular shifting interleaving of FIG. 10 is expressed in an MxN matrix as shown below.

[Table 6]

| input sequence (M = 6, N = 5) | | | | | interleaved sequence (M=6, N=5, p=6) | | | | |
|---|---|---|---|---|---|---|---|---|---|
| 0 | 1 | 2 | 3 | 4 | 0 | 6 | 12 | 18 | 24 |

(continued)

| input sequence (M = 6, N = 5) | | | | | interleaved sequence (M=6, N=5, p=6) | | | | |
|---|---|---|---|---|---|---|---|---|---|
| 5 | 6 | 7 | 8 | 9 | 0 | 6 | 12 | 18 | 24 |
| 10 | 11 | 12 | 13 | 14 | 0 | 6 | 12 | 18 | 24 |
| 15 | 16 | 17 | 18 | 19 | 0 | 6 | 12 | 18 | 24 |
| 20 | 21 | 22 | 23 | 24 | 0 | 6 | 12 | 18 | 24 |
| 25 | 26 | 27 | 28 | 29 | 0 | 6 | 12 | 18 | 24 |

A second circular interleaving scheme includes enabling interleaving of the case with the GCD (SIZE, p) ≠ 1, as shown in FIG. 11. The second circular shifting interleaving is a data reordering procedure in which an input sequence is viewed as a matrix of d x SIZE/d, rows are first circular shifting interleaved, and columns are block interleaved.

FIG. 11 is a flowchart of the second circular shifting interleaving which is applicable regardless of the GCD (SIZE, p) = 1 or ≠ 1. In the second circular shifting interleaving operation, input information bits are stored in a sequential address old_addr[k] of a memory and size is determined, in step 721. Here, SIZE is a parameter indicative of the size of input data. Parameters P and STEP for circular shifting interleaving are determined in step 723. In step 725, second circular shifting interleaving addresses are achieved by equation (5):

$$d = GCD\ (P,\ SIZE);$$
$$for\ (k - j = 0;\ j < d;\ j + + )$$
$$new\ addr[k] = ((P * i + STEP) + j)\ mod\ SIZE\ldots\ldots(5)$$

where i and k are between 0 to SIZE, j is an address parameter, ranging from 0 to d, P is a hop parameter for implementing circular shifting interleaving, and STEP is a parameter determining a start point by shifting data placed in a location set by P to the left or right.

From equation (5), (P x i + STEP) represents a circular shifting interleaving operation and j indicates a block interleaving operation. SIZE is the size of the input data, p is a natural number, and STEP is an integer.

With SIZE = 30 and p = 11, a second circular shifting interleaved outpu is expressed in an M x N matrix as

[Table 7]

| input sequence (M = 6, N = 5) | | | | | interleaved sequence (M=6, N=5, p=11) | | | | |
|---|---|---|---|---|---|---|---|---|---|
| 0 | 1 | 2 | 3 | 4 | 0 | 11 | 22 | 3 | 14 |
| 5 | 6 | 7 | 8 | 9 | 25 | 6 | 17 | 28 | 9 |
| 10 | 11 | 12 | 13 | 14 | 20 | 1 | 12 | 23 | 4 |
| 15 | 16 | 17 | 18 | 19 | 15 | 26 | 7 | 18 | 29 |
| 20 | 21 | 22 | 23 | 24 | 10 | 21 | 2 | 13 | 24 |
| 25 | 26 | 27 | 28 | 29 | 5 | 16 | 27 | 8 | 19 |

which is the same as that of table 6. Yet, with the GCD (SIZE, p) ≠ 1,

[Table 8]

| input sequence (M = 6, N = 5) | | | | | interleaved sequence (M=6, N=5, p=15) | | | | |
|---|---|---|---|---|---|---|---|---|---|
| 0 | 1 | 2 | 3 | 4 | 0 | 15 | 1 | 16 | 2 |
| 5 | 6 | 7 | 8 | 9 | 17 | 3 | 18 | 4 | 19 |
| 10 | 11 | 12 | 13 | 14 | 5 | 20 | 6 | 21 | 7 |
| 15 | 16 | 17 | 18 | 19 | 22 | 8 | 23 | 9 | 24 |
| 20 | 21 | 22 | 23 | 24 | 10 | 25 | 11 | 26 | 12 |
| 25 | 26 | 27 | 28 | 29 | 27 | 13 | 28 | 14 | 29 |

After the input sequence is stored at addresses of a mapped memory, the data is sequentially read by columns or rows by the circular shifting interleaver. Otherwise, the input sequence is sequentially stored in the memory by columns or rows and then read from the addresses bit by bit.

Deinterleaving can be implemented in an order reverse to that of interleaving input data.

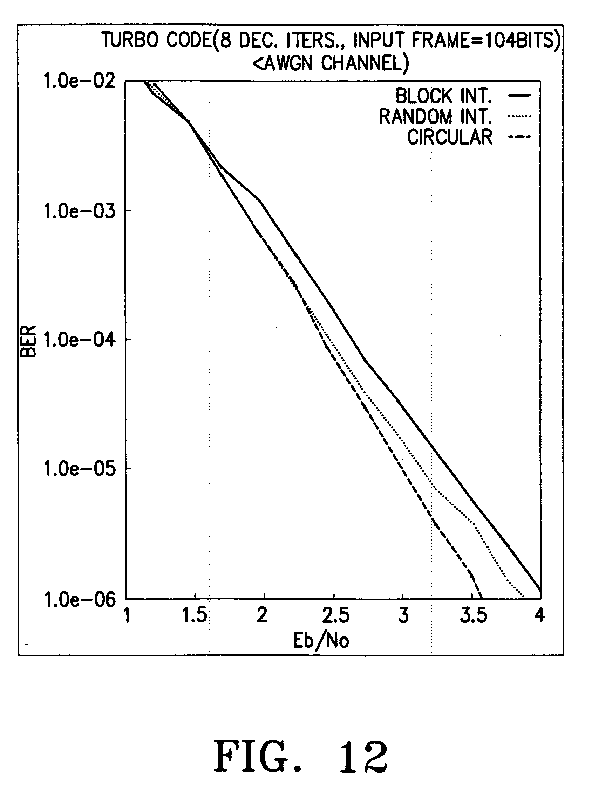

FIG. 12 is a graph showing the performance of the circular shifting interleaver in a parallel concatenated turbo encoder according to the second embodiment of the present invention. Widely used block and random interleavers are compared with the circular shifting interleaver in terms of BER under the condition s of a component code with K = 2, and input 104-bit frame, eight iterative decodings, BPSK (Bi-Phase Shift Key) modulation, and AWGN (Additive White Gaussian Noise). As is noted from FIG. 12, Eb/No of the circular shifting interleaver is 3dB, while that of the block interleaver is 3.4B, under a $10^{-5}$ BER. Thus, it is inferred that the circular shifting interleaver is superior to the block interleaver in performance by about 0.4dB.

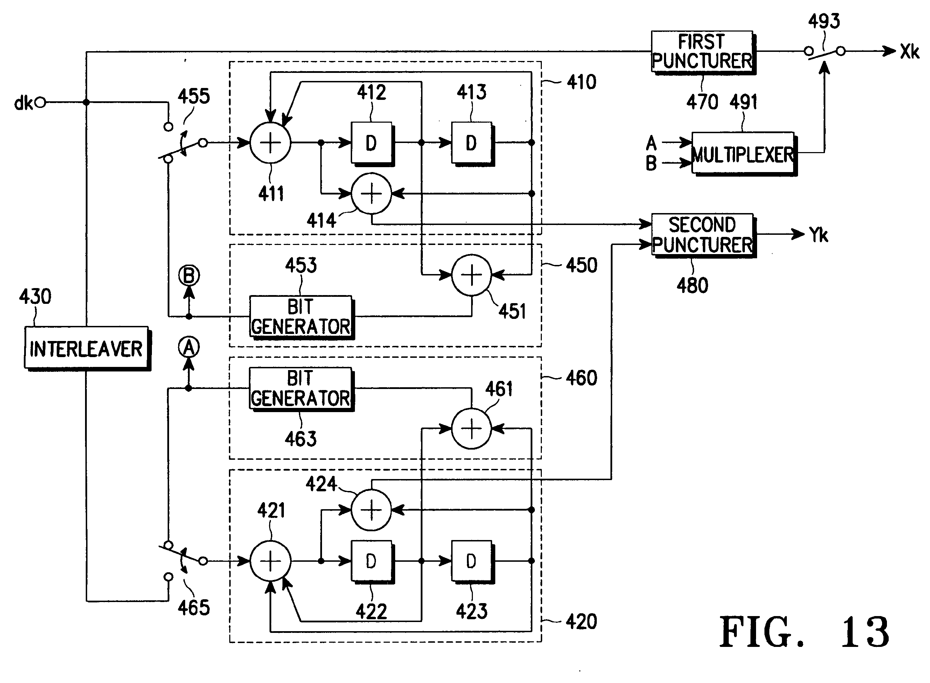

FIG. 13 is a block diagram of a turbo encoder according to an embodiment of the present invention.

Referring to FIG. 13, the first component encoder 410 encodes input information bits with K = 3, for example. The interleaver 430 interleaves the information bits in a predetermined method to thereby modify the order of the information bits. The interleaver 430 can be constituted as shown in FIG. 7. In this case, it may implement one of the first to third diagonal interleavings and the first to third circular shifting interleavings. The second component encoder 420 encodes the output of the interleaver 430 with K = 3, for example.

A first tail bit generator 450 includes a first switch 455 connected to an input port of the first component encoder 410, an exclusive OR gate 451 for performing an exclusive OR operation on output of memories 412 and 413 of the first component encoder 410, and a bit generator 453 for generating a signal for terminating frames according to the output of the exclusive OR gate 451, and applying the signal to the first switch 455. In the first tail bit generator 450, the first switch 455 is connected to the first component encoder 410 upon termination of a frame and a frame termination signal is generated. A second tail bit generator 460 includes a second switch 465 connected to an input port of the second component encoder 420, an exclusive OR gate 461 for performing an exclusive OR operation on outputs of memory devices 422 and 423 of the second component encoder 420, and a bit generator 463 according to the output of the exclusive OR gate 461, generating a frame termination signal, and applying the signal to the second switch 465. In the second tail bit generator 460, the second switch 465 is connected to the second component encoder 420 upon termination of a frame and a frame termination signal is generated.

A first puncturer 470 punctures information bits. A second puncturer 480 punctures encoded data received from the first and second component encoders 410 and 420. The first and second puncturers 470 and 480 serve to adjust a data transmission rate. A multiplexer 491 multiplexes the outputs of the bit generators 453 and 463. A third switch 493 switches tail bits received from the multiplexer 491 to a transmission channel upon termination of a frame.

The first and second tail bit generators 450 and 460 generate tail bits for terminating the operations of the first and second component encoders 410 and 420, respectively. The first and second puncturers 470 and 480 function to adjust a transmission rate to an acceptable level.

Referring to FIG. 13, a turbo code has tail bits for terminating the component encoders 410 and 420. Here, since the component codes of the turbo code is systematic, the memories 412 and 413, and 422 and 423 of the component encoders 410 and 420 are not initialized even with input of consecutive zeroes as in a non-systematic convolutional code. To set values in a memory nearest to the input to zeroes, the first and second component encoders 410 and 420 input the sum of fed-back values to the memories by use of the tail bit generators. Therefore, the turbo encoder requires tail bits as many as memories of each component encoder. The first and second switches 455 and 465 are switched upon generation of tail bits. Then, parity bits generated from tail bits are applied from the first and second component encoders 410 and 420 to the second puncturer 480, and tail bits generated from the tail bit generators are switched by the third switch 493 to be output as information bits $X_k$.

It is desirable to set a transmission rate to a power of 2 in order to reduce hardware complexity. However, the 384kbps transmission rate cannot be a power of 2 using a turbo code with a code rate of 1/2. In this case, the 1/2 turbo code is punctured to a 3/8 turbo code. Especially, in the case of 144kbps, the 1/2 turbo code is punctured to be a 9/16 turbo code. 9/16 puncturing matrixes are exemplarily shown in

[Table 9]

| information bits | 111111111111111111 |
|---|---|
| RSC1 | 1<u>00</u>101<u>0</u>01010<u>0</u>10010 |
| RSC2 | 01<u>00</u>10010100101<u>00</u>1 |

[Table 10]

| information bits | 111<u>0</u>11110111<u>0</u>11110 |
|---|---|
| RSC1 | 101010101010101010 |

(continued)

| RSC2 | 010101010101010101 |

In tables 9 and 10, information bits are $d_k$, applied to the first puncturer 470, and RSC1 are parity bits applied from the first component encoder 410 to the second puncturer 480. Here, table 9 exemplarily shows puncturing of parity bits output from the component encoders 410 and 420. In this case, there are several consecutive zeroes corresponding to parity bits. That is, when the parity bits are punctured to adjust a transmission rate, zeroes successively appear as indicated by underlines in table 9. However, due to two memories in each of the component encoders 410 and 420, serious errors can be generated unless two or more parity bits are consecutively transmitted. Therefore, the information bits are punctured as shown in table 10 in the present invention. Table 10 shows a 9/16 puncturing matrix different from that of table 9 in that two or more parity bits are successively transmitted. Yet, the performance of the turbo code gets better as the number of iterative decodings increases.

According to the present invention as described above, a turbo code, which was unacceptable for voice and data transmission in a communication system due to time delay, can find its application in voice and data transmission with the introduction of an interleaver having a reduced size and showing excellent performance with respect to the turbo code in a turbo encoder. Furthermore, the interleaver having excellent performance reduces the state number of a component encoder in the turbo encoder, thereby decreasing the complexity of a decoder, in turn. Also in accordance with one embodiemtn of the present invention as described above, a variety of encoding rates can be provided by puncturing the input information.

While the present invention has been described in detail with reference to the specific embodiments, they are mere exemplary applications. Thus, it is to be clearly understood that many variations can be made by one skilled in the art within the scope of the present invention as set forth by the appended claims.

**Claims**

1. A turbo coder for encoding input information bits comprising
   a first component encoder (410) for encoding the input information bits in a frame to generate first parities;
   an interleaver (430) for interleaving the input information bits;
   a second component encoder (420) for encoding the interleaved input information bits to generate second parities;
   a first tail bits generator (450) for generating first tail bits being equal to fed-back values of the first component encoder for terminating the first component encoder;
   a second tail bits generator (460) for generating second tail bits being equal to fed-back values of the second component encoder for terminating the second component encoder;
   a first switch (455) for switching the fed-back value of the first component encoder to the first component encoder as the first tail bits at the end of the frame; and
   a second switch (465) for switching the fed-back values of the second component encoder to the second component encoder as the second tail bits at the end of the frame,
   wherein each of the component encoder requires the tail bits as many as memories of the component encoder **characterized by** being arranged for coding input information bits of variable frame sizes, by a first puncturer (470) for puncturing the input information bits and by a multiplexer (491) for multiplexing the first tail bits and the second tail bits into the punctured input information bits.

2. The turbo coder of claim 1, further comprising:

   a second puncture (480) for puncturing one of the first parity or the second parity at a time.

3. The turbo coder of claim 1, wherein the first component encoder is arranged to encode the variable input information bits or the first tail bits, and the second component encoder is arranged to encode the interleaved variable input information bits or the second tail bits.

4. The turbo coder of claim 3, arranged to feed the tail bits to each component encoder after all of the input information bits are encoded.

5. A channel encoding method for use in a channel encoder having a first component encoder and a second component encoder, comprising the steps of:

receiving input information bits:

generating first parity bits for the input information bits and first fed-back value by the first component encoder;
interleaving the input information bits adaptively according to the number of input information bits;
generating second parity bits of the interleaved input information bits and second fed-back value by the second component encoder; and
generating first tail bits and second tail bits being equal to the first and second fed-back values for terminating memories in the first and second component encoders and feeding the tail bits to the first and second component encoders; and
wherein each of the component encoder requires the tail bits as many as memories of the component encoder **characterized by** input information bits of variable frame sizes, and by the steps of puncturing the outputs of the component encoders to adjust a transmission rate, puncturing the input information bits and multiplexing the first tail bits and the second tail bits into the punctured input information bits.

6. The channel encoding method of claim 5, wherein the tail bits are fed to each component encoder after all of the input information bits are encoded.

**Patentansprüche**

1. Turbocodierer zum Codieren von Eingangs-Informationsbits, der umfasst:

einen ersten Teilcodierer (410) zum Codieren der Eingangs-Informationsbits in einem Rahmen, um erste Paritäten zu erzeugen;
einen Interleaver (430) für Interleaving der Eingangs-Informationsbits;
einen zweiten Teilcodierer (420) zum Codieren der Interleaving unterzogenen Eingangs-Informationsbits, um zweite Paritäten zu erzeugen;
einen ersten Endbit-Generator (450) zum Erzeugen erster Endbits, die Rückführwerten des ersten Teilcodierers gleich sind, um den ersten Teilcodierer abzuschließen;
einen zweiten Endbit-Generator (460) zum Erzeugen zweiter Endbits, die Rückführwerten des zweiten Teilcodierers gleich sind, um den zweiten Teilcodierer abzuschließen;
eine erste Verschiebeeinrichtung (455) zum Verschieben des Rückführwertes des ersten Teilcodierers zu dem ersten Teilcodierer als die ersten Endbits am Ende des Rahmens; und
eine zweite Verschiebeeinrichtung (465) zum Verschieben des Rückführwertes des zweiten Teilcodierers zu dem zweiten Teilcodierer als die zweiten Endbits am Ende des Rahmens,
wobei jeder der Teilcodierer so viele der Endbits wie Speicher des Teilcodierers erfordert, die zum Codieren von Eingangs-Informationsbits variabler Rahmengrößen eingerichtet sind, und eine Bitzahl codierter Bits für die Informationsbits sich von einer Bitzahl codierter Bits für die Endbits unterscheidet.

2. Turbocodierer nach Anspruch 1, der des Weiteren umfasst:

eine Punktiereinrichtung zum Punktieren jeweils der ersten Parität oder der zweiten Parität.

3. Turbocodierer nach Anspruch 1, der des Weiteren umfasst:

einen Multiplexer zum Multiplexieren der ersten Endbits und der zweiten Endbits.

4. Turbocodierer nach Anspruch 1, wobei der erste Teilcodierer die Eingangs-Informationsbits oder die ersten Endbits codiert, um die ersten Paritätsbits zu erzeugen, und der zweite Teilcodierer die Interleaving unterzogenen Eingangs-Informationsbits oder die zweiten Endbits codiert, um die zweiten Paritätsbits zu erzeugen.

5. Kanalcodiervorrichtung nach Anspruch 4, wobei die Endbits jedem Teilcodierer zugeführt werden, nachdem alle Eingangs-Informationsbits codiert sind.

6. Kanalcodierverfahren zum Einsatz in einem Kanalcodierer mit einem ersten Teilcodierer und einem zweiten Teilcodierer, wobei es die folgenden Schritte umfasst:

Empfangen von Eingangsinformationsbits;

Erzeugen erster Paritätsbits für die Eingangs-Informationsbits und eines ersten Rückführwertes durch den ersten Teilcodierer;

adaptives Interleaving der Eingangs-Informationsbits entsprechend der Zahl von Eingangs-Informationsbits;

Erzeugen zweiter Paritätsbits der Interleaving unterzogenen Eingangs-Informationsbits und eines zweiten Rückführwertes durch den zweiten Teilcodierer; und

Erzeugen erster Endbits und zweiter Endbits, die dem ersten und dem zweiten Rückführwert gleich sind, um Speicher in dem ersten und dem zweiten Teilcodierer abzuschließen, und Zuführen der Teilbits zu dem ersten sowie dem zweiten Teilcodierer; und

Punktieren der Ausgänge der Teilcodierer, um eine Senderate zu regulieren,

wobei jeder der Teilcodierer so viele der Endbits wie Speicher des Teilcodierers erfordert, die zum Codieren von Eingangs-Informationsbits variabler Rahmengrößen eingerichtet sind, und eine Bitzahl codierter Bits für die Informationsbits sich von einer Bitzahl codierter Bits für die Endbits unterscheidet.

**7.** Kanalcodierverfahren nach Anspruch 6, wobei die Endbits jedem Teilcodierer zugeführt werden, nachdem alle Eingangs-Informationsbits codiert sind.


## Revendications

**1.** Encodeur turbo pour encoder des bits d'informations d'entrée, comprenant ;

un premier encodeur de composants (410) pour encoder les bits d'informations d'entrée dans une trame afin de générer une première parité ;

un entrelaceur (430) pour entrelacer les bits d'informations d'entrée ;

un second encodeur de composants (420) pour encoder les bits d'informations d'entrée entrelacés afin de générer une seconde parité ;

un premier générateur de bits d'extrémité (450) pour générer des premiers bits d'extrémité égaux à une valeur de retour du premier encodeur de composants pour terminer le premier encodeur de composants ;

un second générateur de bits d'extrémité (460) pour générer des seconds bits d'extrémité égaux à une valeur de retour du second encodeur de composants pour terminer le second encodeur de composants ;

un premier commutateur (455) pour commuter la valeur de retour du premier encodeur de composants vers le premier encodeur de composants en tant que premiers bits d'extrémité à la fin de la trame ; et

un second commutateur (465) pour commuter la valeur de retour du second encodeur de composants vers le second encodeur de composants en tant que seconds bits d'extrémité à la fin de la trame ;

dans lequel chacun des encodeurs de composants requiert autant de bits d'extrémité que de mémoires de l'encodeur de composants agencées pour coder les bits d'informations d'entrée de tailles de trame variables et un nombre binaire de bits encodés pour les bits d'informations est différent d'un nombre binaire de bits encodés pour les bits d'extrémité.

**2.** Encodeur turbo selon la revendication 1, comprenant en outre :

un perforateur pour perforer l'une de la première parité ou de la seconde parité à un temps donné.

**3.** Encodeur turbo selon la revendication 1, comprenant en outre :

un multiplexeur pour multiplexer les premiers bits d'extrémité et les seconds bits d'extrémité.

**4.** Encodeur turbo selon la revendication 1, dans lequel le premier encodeur de composants encode les bits d'informations d'entrée ou les premiers bits d'extrémité pour générer les premiers bits de parité, et le second encodeur de composants encode les bits d'informations d'entrée entrelacés ou les seconds bits d'extrémité pour générer les seconds bits de parité.

**5.** Dispositif d'encodage de canal selon la revendication 4, dans lequel les bits d'extrémité sont introduits vers chaque encodeur de composants après que tous les bits d'informations d'entrée ont été encodés.

**6.** Procédé d'encodage de canal destiné à être utilisé dans un encodeur de canal possédant un premier encodeur de composants et un second encodeur de composants, comprenant les étapes consistant à :

recevoir des bits d'informations d'entrée ;

générer des premiers bits de parité pour les bits d'information d'entrée et une première valeur de retour par le premier encodeur de composants ;

entrelacer les bits d'informations d'entrée de façon adaptative en fonction du nombre de bits d'informations d'entrée ;

générer des seconds bits de parité des bits d'informations d'entrée entrelacés et une seconde valeur de retour par le second encodeur de composants ; et

générer des premiers bits d'extrémité et des seconds bits d'extrémité égaux aux première et seconde valeurs de retour pour terminer les mémoires dans les premier et second encodeurs de composants et introduire les bits d'extrémité vers les premier et second encodeurs de composants ; et

perforer les sorties des encodeurs de composants afin d'ajuster un taux de transmission ;

dans lequel chacun des encodeurs de composants requiert autant de bits d'extrémité que de mémoires de l'encodeur de composants agencées pour coder les bits d'informations d'entrée de tailles de trame variables et un nombre binaire de bits encodés pour les bits d'informations est différent d'un nombre binaire de bits encodés pour les bits d'extrémité.

7. Procédé d'encodage de canal selon la revendication 6, dans lequel les bits d'extrémité sont introduits vers chaque encodeur de composants après que tous les bits d'informations d'entrée ont été encodés.

(PRIOR ART)

# FIG. 1

(PRIOR ART)

# FIG. 2

(PRIOR ART)
FIG. 3

(PRIOR ART)
# FIG. 4

$d_K$ ——————————•——————————————— $X_K$

410
FIRST
ENCODER ——— $Y1_K$

432 ~ DIAGONAL
INTERLEAVER

420
SECOND
ENCODER ——— $Y2_K$

# FIG. 5

$d_K$ ——————————•——————————————— $X_K$

410
FIRST
ENCODER ——— $Y1_K$

434 ~ CIRCULAR
SHIFTING
INTERLEAVER

420
SECOND
ENCODER ——— $Y2_K$

# FIG. 6

432,434

523

$d_K$ ⟶ MEMORY ⟶ do

READ ADDRESS

MULTIPLEXER ─ 521

517
DIAGONAL INTERLEAVING CONTROLLER

519
CIRCULAR SHIFTING INTERLEAVING CONTROLLER

M N P STEP

DIAGONAL INTERLEAVING TABLE

CIRCULAR SHIFTING INTERLEAVING TABLE

513 515

REGISTER ─ 511

FRAME INTERLEAVER
SIZE TYPE
SIGNAL SIGNAL

FROM CONTROLLER

FIG. 7

START

611 — INPUT DATA
OLD-ADDR[K], (K=M*N)

613 — DETERMINE M AND
N VALUES

615

GCD (M, N)=1?    NO

619

INTERLEAVING
FAILURE

YES

617 — OPERATE INTERLEAVER
ADDRESS
FOR(K=0;K<M*N−1;K++)
NEW_ADDR[K]=
(M−1)−(K mod M)*
N+(K mod N)

END

# FIG. 8

START

631 — INPUT DATA
OLD_ADDR[K], (K=M*N)

633 — DETERMINE M AND
N VALUES

635 — OPERATE INTERLEAVER
ADDRESSES
FOR(j=0; j, M; j++)
FOR(i=0; j<N; i++)
NEW_ADDR[i+j*N]=
i+(M−1−(i+j) mod M)*N

END

# FIG. 9

FIG. 10

START

721 — INPUT DATA
OLD_ADDR[K], (SIZE=M*N)

723 — DETERMINE PARAMETERS
P AND STEP

725 — OPERATE INTERLEAVER
ADDRESSES
d=gcd(P, SIZE);
FOR (K=j=0; j<d; j++)
FOR (i=0; i<SIZE/d; i++, K++)
NEW_ADDR[i]=
[(P*i+STEP)+j] mod SIZE

END

FIG. 11

FIG. 12

FIG. 13

EP 0 997 031 B1

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 5446747 A, Berrou

**Non-patent literature cited in the description**

- **BENEDETTO.** *IEEE Electronics Letters,* June 1996, vol. 32 (13
- *Proceedings of IEEE Vehicular Technology Conference,* May 1993, 941-944
- *IEEE Transactions on Information Theory,* March 1996, vol. 42 (2), 429-445
- **W. BLACKERT et al.** Turbo code termination and interleaver condition. *Electronic Letters,* 23 November 1995, vol. 31 (24
- **BÖMER et al.** A CDMA Radio link with Turbo-Decoding: Concept and Performance Evaluation. *6th IEEE Symposium on Personal, Indoor and Mobile Radio Communications,* 27 September 1995, 788-793
- **D. DIVSALAR ; F. POLLARA.** Turbo Codes for Deep-Space Communications. *TDA progress report 42-120, Jet Propulsion Laboratory,* 15 February 1995, 29-39